Europäisches Patentamt

European Patent Office

Office européen des brevets

(11) Veröffentlichungsnummer: **0 286 919**

**A2**

(12) # EUROPÄISCHE PATENTANMELDUNG

(21) Anmeldenummer: **88105225.2**

(22) Anmeldetag: **31.03.88**

(51) Int. Cl.⁴: **G03F 3/10**

(30) Priorität: **15.04.87 US 38739**

(43) Veröffentlichungstag der Anmeldung:
**19.10.88 Patentblatt 88/42**

(84) Benannte Vertragsstaaten:
**DE FR GB**

(71) Anmelder: **HOECHST CELANESE
CORPORATION
Route 202-206 North
Somerville, N.J. 08876(US)**

(72) Erfinder: **Platzer, Stephan J. W.
R.R. No. 1, Box 91, Wildwood Road
Califon. New Jersey 07830(US)**

(74) Vertreter: **Neubauer, Hans-Joachim
KALLE Niederlassung der Hoechst AG
Patentabteilung Postfach 3540
Rheingaustrasse 190
D-6200 Wiesbaden1(DE)**

(54) **Verfahren zur Herstellung und Übertragung eines Mehrfarbenbilds.**

(57) Es wird ein Verfahren zur Herstellung eines Mehrfarbenbilds beschrieben, bei dem man ein lichtempfindliches Material aus einem temporären Schichtträger, einer lichtempfindlichen Schicht, die einen Farbstoff oder ein Pigment einer bestimmten Grundfarbe enthält, unter Anwendung von Wärme und Druck auf ein temporäres Bildempfangsmaterial laminiert, die lichtempfindliche Schicht vor oder nach dem Laminieren unter dem zugehörigen Farbauszugsbild belichtet, den temporären Schichtträger vor oder nach dem Belichten abzieht und die Schicht durch Auswaschen der Nichtbildstellen zu einem ersten Teilfarbenbild entwickelt, danach in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt, auf das erhaltene Mehrfarbenbild eine Schutzfolie, die eine Basisfolie, eine zweite Haftschicht und ggf. eine Antiblockierschicht zwischen der Basisfolie und der zweiten Haftschicht aufweist, laminiert, das Bildempfangsmaterial abzieht und das Mehrfarbenbild auf einen permanenten Bildträger laminiert, der in Struktur und Aussehen dem Bedruckstoff entspricht, auf den das entsprechende Mehrfarben-Druckbild gedruckt werden soll. Das Verfahren liefert ein Farbprüfbild, dessen Träger dem späteren Bedruckstoff entspricht und dessen Aussehen dadurch dem späteren Druckbild besser angeglichen ist.

EP 0 286 919 A2

## Verfahren zur Herstellung und Übertragung eines Mehrfarbenbilds

Im Mehrfarbendruck wird im allgemeinen eine Farbprüfung vorgenommen, um die Korrektur der für die Belichtung von Druckplatten verwendeten Farbauszüge zu ermöglichen. Das Prüfbild muß ein getreues Abbild des gewünschten Raster-oder Strichbildes sein und soll den Tonwert der Farben weder erhöht noch herabgesetzt wiedergeben. Die visuelle Farbprüfung soll folgendes aufzeigen:

1. Fehler in der Photomaske,

2. die beste Farbwiedergabe, die beim Drucken in der Druckmaschine von dem Material zu erwarten ist,

3. die genaue Gradation aller Farbtöne und ob die Grautöne neutral sind,

4. die eventuelle Notwendigkeit zur Abschwächung einer der Farben und/oder Hinweise zur Änderung der Filmvorlage vor der Herstellung der Druckplatten.

Farbprüfbilder für den Mehrfarbendruck werden bisher mit Hilfe von Farbandrucken hergestellt. Dabei müssen alle auch beim tatsächlichen Mehrfarbendruck notwendigen Schritte unternommen werden. Ein solches Farbprüfverfahren ist kostspielig und zeitaufwendig, und man hat deshalb alternative Farbprüfverfahren entwickelt, die den Andrucken in der Qualität gleichkommen sollen. Zwei photographische Farbprüfverfahren sind bekannt, nämlich das sogenannte Surprint-Verfahren (Übereinanderkopieren) und das sogenannte Overlay-Verfahren (Übereinanderlegen).

Beim Farbprüfen nach dem Overlay-Verfahren wird auf jeweils einem transparenten Kunststoffträger von jedem Farbauszug für sich ein Teilfarbenbild hergestellt. Zur Herstellung eines Farbprüfsatzes werden dann mehrere solcher mit Teilfarbenbildern versehener Träger übereinander auf ein weißes Blatt gelegt. Das Overlay-Verfahren hat den Nachteil, daß die übereinanderliegenden Kunststoffträger dazu neigen, das Mehrfarbenbild dunkler zu machen, so daß der Eindruck, den man von dem so angefertigten Farbprüfsatz erhält, sich sehr stark von den Drucken unterscheidet, die man mit einem konventionellen Farbandruck erzielt. Der Hauptvorteil dieses Verfahrens besteht darin, daß es schnell ist und durch passergenaues Kombinieren von jeweils zwei oder mehreren Teilfarbenbildern zur Prüfung von Korrekturmaßnahmen dienen kann.

Bei der Prüfung nach dem Surprint-Verfahren wird ein Farbprüfbild angefertigt, indem nacheinander Bilder in verschiedenen Farben von verschiedenen Farbauszügen auf einem einzigen Empfangsblatt hergestellt werden. Dazu wird nur ein undurchsichtiger Träger verwendet, auf den nacheinander Toner oder lichtempfindliche Schichten in den entsprechenden Farben aufgebracht werden, wie es zum Beispiel in der US-A 3 671 236 beschrieben ist. Das Surprint-Verfahren hat den Vorteil, daß die Farbsättigung nicht durch übereinanderliegende Kunststoffträger beein flußt wird. Dieses Verfahren kommt dem tatsächlichen Druck näher und vermeidet die dem Overlay-Verfahren eigene Farbverfälschung.

In der US-A 3 721 557 wird ein Verfahren zur Übertragung von Farbbildern beschrieben, bei dem zwischen der lichtempfindlichen Schicht und dem Träger eine Abziehschicht aufgebracht ist. Wenn die lichtempfindliche Schicht belichtet und entwickelt wird, werden die löslicheren Teile der Schicht selektiv entfernt, und es entsteht ein sichtbares Bild. Der Träger mit dem Bild wird gegen ein geeignetes klebstoffbeschichtetes Empfangsmaterial gepreßt und dann die Bildübertragung durch Abziehen des Trägers vorgenommen. Für jede weitere Bildübertragung wird eine frische Klebstoffschicht auf das Empfangsmaterial aufgetragen.

In der EP-A 182 031 wird ein Verfahren zur Herstellung eines Mehrfarbenbilds beschrieben, bei dem ein lichtempfindliches Material aus einem temporären Schichtträger, einer lichtempfindlichen Schicht, die ein Polyvinylbutyral und bzw. oder ein Styrol-Maleinsäurehalbester-Copolymeres als Bindemittel, ein Diazoniumsalz-Polykondensationsprodukt und einen Farbstoff oder ein Pigment einer bestimmten Grundfarbe enthält, und einer Haftschicht auf der lichtempfindlichen Schicht, die ein Vinylacetatpolymeres enthält und einen Erweichungspunkt im Bereich von 60 bis 180 °C hat, auf einen permanenten Schichtträger unter Druck und Erwärmen laminiert, die lichtempfindliche Schicht bildmäßig belichtet, der temporäre Schichtträger abgezogen und die belichtete Schicht durch Auswaschen der unbelichteten Bereiche entwickelt wird, wobei man entweder

a) nach dem Laminieren zuerst den temporären Schichtträger abzieht und danach die lichtempfindliche Schicht bildmäßig belichtet oder

b) nach dem Laminieren zuerst die lichtempfindliche Schicht belichtet und danach den temporären Schichtträger abzieht oder

c) zuerst die lichtempfindliche Schicht belichtet, dann das belichtete lichtempfindliche Material auf den permanenten Schichtträger laminiert und schließlich den temporären Schichtträger abzieht, und vorstehenden Schritte mindestens einmal mit einem lichtempfindlichen Material wiederholt, das einen Farbstoff oder ein Pigment in einer anderen Grundfarbe enthält.

Bei der Herstellung von Farbprüfbildern besteht das Problem, daß die Schichten nur auf ein besonders behandeltes endgültiges Empfangsblatt übertragen werden können. Der Hersteller von Farbprüffolien wird also seinem Kunden normalerweise ein spezielles weißes Empfangsblatt zur Verfügung stellen, auf das die Bilder auflaminiert werden. Die auflaminierten Schichten haften fest auf diesem Blatt, so daß die temporären Träger, auf die die farbigen lichtempfindlichen Schichten zuvor aufgebracht waren, abgezogen werden können. Hierfür werden spezielle Empfangsblätter gebraucht, die dem für die Herstellung eines Mehrfarbenprüfbilds erforderlichen mehrfachen Entwickeln und Laminieren standhalten. Der notwendige Einsatz eines speziellen Empfangsblatts hat jedoch den Nachteil, daß man das Mehrfarbenprüfbild nicht auf dem Papier betrachten kann, das tatsächlich zum Drucken verwendet wird. Die vorliegende Erfindung löst dieses Problem durch ein Farbprüfverfahren, das das fertige Mehrfarbenbild auf irgendeinem gewünschten Trägermaterial liefert. Es sind nicht nur verschiedenartige Papiere verwendbar, sondern man kann auch beide Seiten des Papiers nutzen und für die Layoutanalyse mehrere kleine Prüfbilder nacheinander auf ein größeres Blatt auflaminieren.

Gegenstand der Erfindung ist ein Verfahren zur Herstellung eines Mehrfarbenbildes, bei dem man ein lichtempfindliches Material aus einem temporären Schichtträger, einer lichtempfindlichen Schicht, die einen Farbstoff oder ein Pigment einer bestimmten Grundfarbe enthält, ggf. einer ersten wärmeaktivierbaren Haftschicht auf der lichtempfindlichen Schicht und ggf. einer ungefärbten, lichtempfindlichen oder nicht lichtempfindlichen Sperrschicht zwischen der farbigen lichtempfindlichen Schicht und der ersten Haftschicht unter Anwendung von Wärme und Druck auf ein temporäres Bildempfangsmaterial laminiert, die lichtempfindliche Schicht vor oder nach dem Laminieren unter dem zugehörigen Farbauszugsbild belichtet, den temporären Schichtträger vor oder nach dem Belichten abzieht und die Schicht durch Auswaschen der Nichtbildstellen zu einem ersten Teilfarbenbild entwickelt und bei dem man in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt.

Das erfindungsgemäße Verfahren ist dadurch gekennzeichnet, daß man auf das erhaltene Mehrfarbenbild eine Schutzfolie, die eine Basisfolie, eine zweite Haftschicht und ggf. eine Antiblockierschicht zwischen der Basisfolie und der zweiten Haftschicht aufweist, laminiert, das Bildempfangsmaterial abzieht und das Mehrfarbenbild auf einen permanenten Bildträger laminiert, der in Struktur und Aussehen dem Bedruckstoff entspricht, auf den das entsprechende Mehrfarben-Druckbild gedruckt werden soll.

Aus den in den Patentansprüchen beschriebenen Verfahrensschritten wird deutlich, daß der lichtempfindliche Schichtaufbau auf dem temporären Bildempfangsmaterial stärker haftet als auf seinem ursprünglichen temporären Träger. Desgleichen haftet die Haftschicht der Schutzfolie (2. Haftschicht) stärker auf den Bildschichten als der lichtempfindliche Schichtaufbau auf dem temporären Bildempfangsmaterial oder als die gegebenenfalls vorhandene Haftschicht dieses Bildempfangsmaterials (3. Haftschicht) auf ihrem Trägermaterial.

Soll schließlich die Basisfolie der Schutzfolie entfernt werden, so ist die Haftung der Schichten auf dem permanenten Bildträger größer als die Haftung der Basisfolie an ihrer Haftschicht oder gegebenenfalls an ihrer Antiblockierschicht.

Zur Durchführung des erfindungsgemäßen Verfahrens wird ein lichtempfindliches Material verwendet, das, wie oben beschrieben, generell aus einem Schichtträger mit einem darauf aufgebrachten farbigen lichtempfindlichen Schichtaufbau besteht.

In bevorzugter Ausführung besteht der Träger aus einer maßbeständigen und chemisch stabilen Kunststoffolie. Ein bevorzugtes Material ist Polyethylenterephthalat, das normalerweise eine Dicke von etwa 25 - 250 μm, vorzugsweise etwa 50 - 130 μm und insbesondere etwa 50 - 75 μm aufweist. Geeignete Folien sind zum Beispiel Hostaphan 3000 (Hersteller Hoechst Celanese Corporation), Mylar D (Hersteller DuPont) und Melinex in den Qualitäten 0, 052, 442, 516 und S (Hersteller ICI). Der Schichtträger kann transparent, undurchsichtig, glasklar oder farbig sein. Die Oberfläche des Trägers kann glatt sein, oder sie kann nach verschiedenen bekannten Verfahren mit einer matten Struktur versehen werden. Als matte Folien sind zum Beispiel Melinex 377 und 470 von ICI geeignet. Der Träger hat entweder von Natur aus eine wenig haftende Oberfläche, oder er wird durch Aufbringen einer Polyvinylalkohol-Beschichtung mit einer solchen Oberfläche versehen.

Auf der wenig haftenden Oberfläche des Trägers befindet sich ein farbiger, lichtempfindlicher Schichtaufbau mit einer lichtempfindlichen Schicht. Die lichtempfindliche Schicht beteht generell aus einer positiv oder negativ arbeitenden lichtempfindlichen Verbindung, einem Farbmittel, einem Harz als Bindemittel und ggf. anderen üblichen Bestandteilen, z. B. Weichmachern, thermoplastischen Klebern, sauren Stabilisatoren, Netzmitteln, Antistatika, UV-Absorbern, Dispergierhilfsmitteln und Lösemittelresten vom Beschichten.

Als lichtempfindliche Verbindung wird vorzugsweise ein lichtempfindliches Diazoniumsalz, ein Chinondiazid oder ein photopolymerisierbares oder photovernetzbares Gemisch verwendet. Das bevorzugte Chinondiazid ist das Veresterungsprodukt aus Bis-(3-benzoyl-4,5,6-trihydroxy-phenyl)-methan und 1,2-Naphthochinon-2-diazid-5-sulfonsäure, gemäß US-A 4 407 426. Andere geeignete Chinondiazide sind aus den US-A 4 266 001, 3 106 365, 3 148 983 und 3 201 239 bekannt.

Die am meisten bevorzugte lichtempfindliche Verbindung ist das Polykondensationsprodukt aus 3-Methoxy-diphenylamin-4-diazoniumsulfat und 4,4'-Bis-methoxymethyl-diphenylether, ausgefällt als Mesitylensulfonat, wie in der US-A 3 849 392 beschrieben. Weitere geeignete lichtempfindliche Verbindungen sind in der US-A 4 436 804 beschrieben. Die Diazoniumverbindungen sind bevorzugt in organischen Lösemitteln löslich.

Als Bindemittel geeignete Harze sind Polyvinylacetale und Styrol/Maleinsäurehalbester-Copolymere oder Mischungen daraus. Solche Harze sind beispielsweise Butvar B 72, B 76 und B 90 und Scripset 540 bzw. 550, die alle von Monsanto hergestellt werden. Ein wichtiges Kriterium bei der Wahl des Harzes ist, daß es gute Filmbildungseigenschaften haben muß.

Zu den erfindungsgemäß geeigneten Farbmitteln zählen verschiedene Farbstoffe und Pigmente. In der am meisten bevorzugten Ausführung werden Pigmente mit einer durchschnittlichen Teilchengröße von höchstens etwa 1 μm eingesetzt.

Der lichtempfindlichen Schicht können gegebenenfalls Weichmacher vom Phthalat-oder Phosphattyp zugesetzt werden. Bevorzugte Weichmacher sind Dibutylphthalat und Dimethylphthalat. Es können auch polymere Weichmacher eingesetzt werden. Geeignete saure Stabilisatoren sind zum Beispiel Phosphorsäure und p-Toluolsulfonsäure.

Diese Komponenten können in verträglichen Lösemitteln wie Ethanol, 2-Methoxy-ethanol, Diacetonalkohol, Butyrolacton, Propylenglykolmonomethylether und Butanon gelöst werden.

Auf der Oberfläche der lichtempfindlichen Schicht kann noch eine gesonderte, erste Haftschicht mit einem Erweichungspunkt im Bereich von etwa 60 - 180 °C aufgebracht sein, und zwischen lichtempfindlicher Schicht und Haftschicht kann sich eine Sperrschicht befinden, die ein Vermischen der lichtempfindlichen Schicht mit der Haftschicht verhindert. Als Sperrschichten sind z. B. solche aus einem Vinylchlorid-Vinylacetat-Copolymeren und Polymethylmethacrylat in einer Schichtdicke von etwa 0,1 - 5,0 μm geeignet.

Das lichtempfindliche Material wird mittels des Haftvermögens der lichtempfindlichen Schicht oder der Haftschicht auf ein gegen Entwickler resistentes, unter Wärmeeinwirkung maßbeständiges temporäres Bildempfangsmaterial laminiert. Dann wird mit aktinischer Strahlung bildmäßig belichtet und der Schichtträger des lichtempfindlichen Materials entfernt. Die genannten Schritte, Laminieren, Belichten und Entfernen des Schichtträgers, können in der jeweils zweckmäßigen Reihenfolge durchgeführt werden. Laminiert wird unter Druck und Erwärmen.

Das temporäre Bildempfangsmaterial besteht ebenfalls aus einem unter Wärmeeinwirkung maßbeständigen Trägermaterial mit einer wenig haftenden Oberfläche, auf die noch eine farblose thermoplastische Haftschicht (3. Haftschicht) aufgebracht sein kann, die ihrerseits gegebenenfalls mit einer Antiblockierschicht versehen ist, wie nachstehend beschrieben.

Die Nichtbildstellen der lichtempfindlichen Schicht werden dann mit einem Entwickler entfernt. Geeignete Entwickler für die lichtempfindliche Schicht sind bekannt und werden nach dem jeweils verwendeten Photosensibilisator gewählt. Beispiele für geeignete Entwickler sind organische Lösemittel, wäßrige Lösungen von Säuren oder Basen, wäßrige Lösungen von Mono-, Di-und Trinatriumphosphaten und von Alkalisilikaten. Auch Lösungen von oberflächenaktiven Mitteln, z. B. von Natriumtetradecylsulfat, sind geeignet.

Die genannten Verarbeitungsschritte werden für jede von mehreren übereinander angeordneten Bildfarben wiederholt. Gewöhnlich werden vier Bilder auf das Empfangsmaterial aufgebracht, um ein komplettes Farbbild zu erhalten.

Es ist häufig erwünscht, das photographische Bild gegen Kratzer, Verschmutzungen und dergl. zu schützen, die während der Handhabung und beim Transport entstehen können. Aus diesem Grund wird eine Schutzfolie unter Druck und Erwärmen auf die auf dem temporären Bildempfangsmaterial befindliche Bildschicht laminiert. Das Laminieren auf die Bildschicht sollte unter Druck bei relativ niedriger Temperatur durchgeführt werden, da zu hohe Temperaturen das Bild verzerren und verfärben können. Weiterhin soll die Schutzfolie über längere Lagerzeiten im wesentlichen nicht blocken.

Im allgemeinen besteht die auf das Bild aufzubringende Schutzfolie ebenfalls aus einer unter Wärmeeinwirkung maßbeständigen Basisfolie mit wenig haftender Oberfläche, auf die eine Haftschicht aufgebracht ist. In bevorzugter Ausführung ist zwischen Basisfolie und Haftschicht eine weitere Antiblockierschicht angeordnet. Diese Schichten können nach üblichen Beschichtungs-oder Laminierverfahren auf die Basisfolie aufgebracht worden sein. In diesem Fall wird der Verbund aus Haft-und Antiblockierschicht auf der Basisfolie der Schutzfolie auf die mehrfarbige Bildschicht laminiert. Anschließend wird das Trägermaterial des temporären Bildempfangsmaterials abgezogen und der verbleibende Teil mit der freigelegten Klebeschicht auf einen permanenten Bildträger, z. B. aus Papier, beschichtetem Papier, Metall oder einer der vorgenannten Polyesterfolien, laminiert.

In bevorzugter Ausführung können das Trägermaterial für das temporäre Bildempfangsmaterial und die Basisfolie für die Schutzfolie aus einem beliebigen, unter den Bedingungen des Laminierens maßbeständigen Material bestehen. Geeignet sind zum Beispiel Polyester, insbesondere Polyethylenterephthalat. Die Träger können transparent, undurchsichtig, farblos oder farbig sein.

Die Oberfläche des Trägers für das lichtempfindliche Material, des Trägermaterials für das temporäre Bildempfangsmaterial oder der Basisfolie für die Schutzfolie können glatt sein oder nach verschiedenen bekannten Verfahren mattiert worden sein. Eine geeignete glatte Folie ist zum Beispiel Melinex 516 von ICI. Als matte Folie sind zum Beispiel Melinex 329, 377 und 470 von ICI geeignet. Der Glanz des endgültigen Bildes kann durch die richtige Wahl der Oberflächenbeschaffenheit der Basisfolie der Schutzfolie gesteuert werden.

Um ein mattes Aussehen zu erreichen, wird z. B. eine rauhe Folie unter Druck und Erwärmen auf das endgültige Bild laminiert. Anschließend kann die Folie mit der rauhen Oberfläche wieder abgezogen werden. Die rauhe Oberfläche verleiht dem endgültigen Bild ein mattes Aussehen. Die Struktur der geschützten Bildschicht kann durch nachträgliches Auflaminieren eines strukturierten Materials, das nach dem Laminieren wieder abgezogen wird, weiter modifiziert werden. Die Oberflächenstruktur der Bildschicht kann auch durch nachträgliches Behandeln mit Lösemitteln und/oder Partikeln modifiziert werden, wobei ein Teil der Schutzschicht entfernt werden kann.

Die Basisfolie der Schutzfolie kann eine wenig haftende Oberfläche haben, d. h. sie kann befähigt sein, die Haftschicht und die gegebenenfalls vorhandene Antiblockierschicht trennbar zu halten. Dies kann dadurch erreicht werden, daß die Oberfläche entweder von Natur aus wenig haftend ist, durch eine entsprechende Behandlung wenig haftend gemacht wird oder über der Trägeroberfläche mit einer Trennschicht versehen wird. Eine derartige Trennschicht kann aus Polyvinylalkohol bestehen.

Das Trägermaterial des temporären Bildempfangsmaterials muß eine wenig haftende Oberfläche haben, d. h. es muß befähigt sein, die dritte Haftschicht trennbar zu halten. Dies kann dadurch erreicht werden, daß entweder die Trägeroberfläche von Natur aus wenig haftend ist oder durch eine entsprechende Behandlung wenig haftend gemacht wird. Das Bildempfangsmaterial kann vorzugsweise aus einem maßbeständigen und chemisch stabilen Trägermaterial mit einer Haftschicht (3. Haftschicht) bestehen. Die Haftschicht wird während des Laminierens mit dem farbigen Material in Kontakt gebracht. Die Haftschicht stellt sicher, daß ein guter Kontakt zwischen dem farbigen Material und dem Bildempfangsmaterial hergestellt wird. Das Bildempfangsmaterial kann auch aus einem stabilen Trägermaterial bestehen, auf das eine Haftschicht und auf diese wiederum eine Antiblockierschicht aufgebracht ist. Die Antiblockierschicht wird auf das farbige Material laminiert und soll verhindern, daß die erste Farbschicht schon bei Raumtemperatur, vor dem Auflaminieren des ersten farbigen Materials, an dem Bildempfangsmaterial haftet. Die Antiblockierschicht kann auch als flexibler Träger für die Farbschicht(en) und für den permanenten Bildträger dienen.

Die Haftschichten des lichtempfindlichen Materials, des Bildempfangsmaterials und der Schutzfolie haben eine Dicke von etwa 0,5 bis 30 µm, vorzugsweise etwa 1 bis 20 µm und insbesondere etwa 5 bis 15 µm. Der Hauptbestandteil der Haftschicht besteht vorzugsweise aus einem thermoplastischen Polymeren oder einem Gemisch aus thermoplastischen Polymeren, das bei normaler Raumtemperatur im wesentlichen nicht klebrig ist. Als Polymere können thermoplastische Polymere gewählt werden, deren Glasübergangstemperatur (Tg) vorzugsweise zwischen etwa 20 und 80 °C, insbesondere zwischen etwa 25 und 60 °C, liegt und die flexible Filme bilden. Alternativ besteht der Hauptbestandteil der Haftschicht aus einem wärmehärtbaren Polymeren oder aus einem Gemisch von wärmehärtbaren Polymeren, das bei normaler Raumtemperatur im wesentlichen nicht klebrig ist. Die Polymeren sollen vorzugsweise transparent und farblos sein. Die Haftschicht kann ferner Weichmacher, UV-Absorber, Netzmittel, Antistatika, Monomere, Oligomere, Photoinitiatoren, optische Aufheller und Farbmittel enthalten. Als Beispiel für einen polymeren Weichmacher ist Resoflex R-296 (Hersteller Cambridge Industries) zu nennen. Geeignete thermoplastische Polymere sind z. B. Polyvinylacetale, wie Butvar B 79 (Hersteller Monsanto), Polyvinylacetate, wie Mowilith 30 (Hersteller Hoechst AG), Polyacrylate, wie Elvacite 2044 (Hersteller DuPont), Vinylchlorid-Vinylacetat-Copolymere, wie UCAR VMCA (Hersteller Union Carbide). Geeignete wärmehärtbare Polymere sind z. B. Phenolharze, wie Alnovol PN 430 (Hersteller Hoechst AG) und Epoxyharze, wie Polyset EPC 202 (Hersteller Dynachem). Zu den geeigneten Monomeren zählt Sartomer 399 und zu den Oligomeren Sartomer 3000 (Hersteller Arco).

Die Antiblockierschichten haben eine Dicke von etwa 0,2 bis 50 µm, vorzugsweise von 1 bis 10 µm und insbesondere von 2 bis 3 µm. Der Hauptbestandteil der Antiblockierschicht besteht aus einem organischen Polymeren oder einem Gemisch aus organischen Polymeren. Die Bestandteile der Antiblockierschicht werden so gewählt, daß die Schicht bis zu etwa 50 °C, vorzugsweise bis zu etwa 70 °C, nicht blockt. Zur Prüfung auf Blocken werden die in ASTM D 1146 beschriebenen Standardverfahren angewendet.

Als Polymere für die Antiblockierschicht können solche mit einer Glasübergangstemperatur über etwa 60 °C, vorzugsweise über 70 °C, insbesondere über 100 °C, gewählt werden. Die in der Antiblockierschicht enthaltenen Polymeren sollen flexible Filme bilden. Sie sollen vorzugsweise transparent und farblos sein, können jedoch auch Weichmacher, UV-Absorber, Netzmittel, Antistatika und Farbmittel enthalten. Als polymerer Weichmacher ist z. B. Carboset 525 (Hersteller BF Goodrich) zu nennen.

Für die Antiblockierschicht verwendbare Verbindungen sind zum Beispiel Copolymere aus Styrol und Maleinsäureanhydrid, wie Scripset 540 (Hersteller Monsanto), Polyvinylacetale, wie Butvar B 90 (Hersteller Monsanto), Polyacrylate, wie Elvacite 2008 (Hersteller DuPont), Polyvinylacetale, wie sie in der EP-A 216 083 beschrieben sind, und Vinylacetat-Vinylchlorid-Copolymere, wie Hostaflex CM 131 (Hersteller Hoechst Celanese Corporation).

Das Laminieren kann so durchgeführt werden, daß die jeweiligen Schichten miteinander in Kontakt gebracht werden und dann beide Materialien unter entsprechendem Druck zusammen durch den Walzenspalt eines beheizten Laminierwalzenpaares geführt werden. Geeignete Laminiertemperaturen liegen im allgemeinen bei etwa 60 - 90 °C, vorzugsweise bei 75 - 85 °C. Nach dem Laminieren können die Träger des lichtempfindlichen Materials, des temporären Bildempfangsmaterials und der Schutzfolie, die eine wenig haftende Oberfläche besitzen, abgezogen werden, was normalerweise einfach von Hand geschieht.

Die Erfindung wird durch die folgenden Beispiele näher erläutert, in denen alle Mengenangaben, wenn nichts anderes angegeben ist, in Gewichtseinheiten zu verstehen sind.

## Beispiel 1

Zur Herstellung lichtempfindlicher, übertragbarer Schichten werden die folgenden Lösungen jeweils auf eine Polyesterfolie aufgebracht und dann bei 70 °C getrocknet. Die lichtempfindlichen Schichten werden danach mit einer Lösung eines durch Wärme aktivierbaren Klebers überzogen, die anschließend getrocknet wird. Die Beschichtungslösungen haben folgende Zusammensetzung:

|  | Cyan (Blaugrün) | Gelb | Magenta (Purpur) | Schwarz |
|---|---|---|---|---|
| 2-Methoxy-ethanol | 41,00 | 41,00 |  | 41,00 |
| Butanon | 41,00 | 40,90 | 10,51 | 41,00 |
| Butyrolacton | 10,00 | 10,00 |  | 10,00 |
| Propylenglykolmonomethylether |  |  | 30,69 |  |
| Diacetonalkohol |  |  | 25,57 |  |
| Tetrahydrofuran |  |  | 13,30 |  |
| Ethanol |  |  | 14,32 |  |
| Dimethylphthalat | 0,75 | 0,75 |  | 0,80 |
| Dibutylphthalat | 0,25 | 0,25 |  | 0,28 |
| Schwefelsäure |  |  |  | 0,07 |
| Scripset 540 (Styrol/Monoiso-butylmaleinat-Copolymeres; Säurezahl 185; $M_n$ 50.000) | 3,33 |  | 2,15 | 0,93 |
| Scripset 550 (Styrol/Maleinsäurepartialester-Copolymeres; SZ 175; $M_n$ 45.000) | 1,17 | 0,70 |  |  |
| hydrolysiertes Scripset 540 |  |  |  | 2,59 |
| Diazoniumsalz | 1,33 | 1,40 | 1,54 | 2,16 |
| Phthalocyaninblau | 1,17 |  | 0,01 |  |
| gelbes Pigment |  | 1,04 |  |  |
| purpurfarbenes Pigment |  |  | 0,89 |  |
| schwarzes Pigment |  |  |  | 0,94 |
| optische Dichte | 1,1 | 0,9 | 1,2 | 1,5 |

Das Diazoniumsalz ist das Polykondensatonsprodukt aus 1 mol 3-Methoxy-diphenylamin-4-diazoniumsulfat und 1 mol 4,4'-Bis-methoxymethyl-diphenylether, ausgefällt als Mesitylensulfonat gemäß US-A 3 849 392. Die Pigmente werden jeweils als Dispersion in einer Lösung von Scripset 540 in Butanon zugegeben. Die Lösungen werden auf zur Verbesserung ihres Gleitverhaltens beidseitig behandelte glasklare Polyethylenterephthalatfolien (Melinex 516) aufgebracht und getrocknet.

Die Kleberlösung wird zu einem Schichtgewicht von jeweils 10 bis 12 g/m² auf die lichtempfindliche Schicht aufgetragen und getrocknet. Die Kleberlösung hat die folgende Zusammensetzung:

n-Butylacetat 78 %
Resoflex R-296 1 %
Mowilith 30 21 %
(Polyvinylacetat; MG 110.000)

Resoflex R-296 ist ein polymerer Weichmacher (Hersteller Cambridge Industries).

Das gelbe lichtempfindliche Material wird mit seiner Haftschicht auf ein 75 μm dickes temporäres Bildempfangsmaterial (Melinex 516) laminiert. Zu diesem Zweck werden lichtempfindliches Material und temporäres Bildempfangsmaterial unter entsprechendem Druck zusammen durch den Walzenspalt eines

7

auf 75 °C aufgeheizten Laminierwalzenpaares geführt. Nach dem Laminieren wird der Träger des gelben Materials einfach von Hand abgezogen, wobei die Haftung der Haftschicht an dem Bildempfangsmaterial größer ist als die Haftung der lichtempfindlichen Schicht an ihrem Träger.

Die lichtempfindliche Schicht wird dann im Kontakt Schicht auf Schicht unter einem Negativauszug für Gelb mit aktinischem Licht bildmäßig belichtet. Das einfallende Licht braucht nicht durch ein Filter geleitet zu werden, wenn das Material hinter dem Bildempfangsmaterial im aktinischen Spektralbereich nicht reflektiert.

Die belichtete lichtempfindliche Schicht wird dann durch Weglösen der nichtbelichteten Bereiche entwickelt. Ein geeigneter Entwickler hat die folgende Zusammensetzung:

Wasser 89,26 %
Mononatriumphosphat 0,27 %
Trinatriumphosphat 2,23 %
Natriumtetradecylsulfat 8,24 %

Die belichtete gelbe Schicht wird 15 Sekunden in den 23 °C warmen Entwickler getaucht und auf der Schichtseite leicht überrieben. Die Haftschicht wird durch den Entwickler nicht angegriffen. Nach dem Entwickeln wird das bebilderte Material abgespült und mit warmer Luft getrocknet.

Als nächstes wird das purpurfarbene Material wie oben beschrieben auf das gelbe Bild laminiert. Dann wird wie zuvor der Träger des purpurfarbenen Materials abgezogen. Die purpurfarbene lichtempfindliche Schicht wird anschließend passergenau unter dem negativen Auszug für diese Farbe belichtet. Die belichtete purpurfarbene Schicht wird dann ebenso wie die gelbe Schicht verarbeitet.

Auf Purpur (Magenta) folgen in gleicher Weise Blaugrün (Cyan) und dann Schwarz, so daß man auf dem temporären Bildempfangsmaterial ein Vierfarbenbild erhält.

Die Schutzfolie besteht aus einer Haftschicht auf einer 75 μm dicken, beidseitig haftvermittelnd behandelten glasklaren Polyethylenterephthalatfolie (Melinex 505). Die Schutzfolie wird so hergestellt, daß die oben beschriebene Kleberlösung mit einem Schichtgewicht von 10 - 12 g/m² auf die Folie aufgetragen und getrocknet wird. Wie oben beschrieben, wird die Schutzfolie mit ihrer Haftschicht direkt auf das Vierfarbenbild laminiert. Das Bildempfangsmaterial wird von Hand abgezogen. Dabei ist die Haftung der Haftschicht der Schutzfolie zu Melinex 505 größer als die Haftung der Haftschicht auf dem Zwischenträger zu Melinex 516. Das Vierfarbenbild wird dann auf Papier der Marke "Mead 2S (70)" laminiert.


Beispiel 2

Es werden die gleichen lichtempfindlichen Materialien wie in Beispiel 1 verwendet, allerdings wird zur Herstellung des Bildempfangsmaterial in diesem Beispiel eine 75 μm dicke Folie Melinex 516 zu einem Schichtgewicht von 5 - 7 g/m² mit der Kleberlösung aus Beispiel 1 beschichtet.

Das blaugrüne lichtempfindliche Material wird wie oben beschrieben auf das Bildempfangsmaterial laminiert, wobei die Haftschicht des farbigen Materials sich in direktem Kontakt mit der Haftschicht des Bildempfangsmaterial befindet. Durch die zusätzliche Haftschicht auf dem Bildempfangsmaterial ergibt sich nach dem Abziehen des Trägers des blaugrünen Materials eine sehr gute Übertragung der blaugrünen lichtempfindlichen Schicht auf das Bildempfangsmaterial.

Die blaugrüne lichtempfindliche Schicht wird dann wie oben beschrieben belichtet und weiterverarbeitet.

Wie zuvor wird dann das gelbe lichtempfindliche Material auf das blaugrüne Bild laminiert, die Trägerfolie des gelben Materials abgezogen und die gelbe lichtempfindliche Schicht belichtet und weiterverarbeitet.

Auf Gelb folgen noch Purpur und dann Schwarz, so daß man ein Vierfarbenbild auf dem Bildempfangsmaterial erhält.

Die Schutzfolie ist ähnlich wie die in Beispiel 1. Sie wird so hergestellt, daß eine 75 μm dicke Folie (Melinex 505) zu einem Schichtgewicht von 6 - 8 g/m² mit der folgenden Kleberlösung beschichtet und dann getrocknet wird:

n-Butylacetat 64 %
Mowilith 30 10 %
Resoflex R-296 1 %
UCAR VYNC 25 %

UCAR VYNC ist ein hydroxy-modifiziertes Vinylchlorid-Vinylacetat-Polymeres (Hersteller UCC). Die Schutzfolie wird mit ihrer Haftschicht direkt auf das Vierfarbenbild laminiert. Das klare Bildempfangsmaterial wird von Hand abgezogen, wobei seine Haftschicht auf dem Vierfarbenbild verbleibt, das anschließend auf Papier der Marke "Mead 2S (70)" laminiert wird.

Beispiel 3

Die lichtempfindlichen Materialien werden wie in Beispiel 1 hergestellt, wobei die lichtempfindlichen Lösungen jedoch die folgende Zusammensetzung haben:

|  | Cyan | Gelb | Magenta | Schwarz |
| --- | --- | --- | --- | --- |
| Butanon | 23,07 | 33,78 | 33,00 | 31,15 |
| Butyrolacton | 8,52 | 6,01 | 6,35 | 8,41 |
| Propylenglykolmonomethylether | 43,94 | 39,81 | 39,66 | 39,54 |
| Diacetonalkohol | 17,79 | 16,89 | 16,50 | 15,58 |

|  | Cyan | Gelb | Magenta | Schwarz |
| --- | --- | --- | --- | --- |
| Scripset 540 | 3,16 | 0,68 | 0,66 |  |
| Polyvinylacetal | 1,06 | 0,74 | 2,08 | 1,03 |
| Carboset XL 27 |  |  |  | 1,56 |
| Diazoniumsalz wie in Beispiel 1 | 1,23 | 1,35 | 0,99 | 1,87 |
| Phthalocyaninblau | 1,14 |  | 0,02 |  |
| gelbes Pigment |  | 0,74 | 0,05 |  |
| purpurfarbenes Pigment |  |  | 0,69 |  |
| schwarzes Pigment |  |  |  | 0,86 |
| optische Dichte | 1,1 | 0,9 | 1,2 | 1,5 |

Das Polyvinylacetal hat 13,6 % Vinylacetat-, 9,8 % Vinylalkohol-und 76,6 % Vinylacetaleinheiten. Von den Acetalgruppen sind 80 % Sechsringacetale, 4 % Fünfringacetale und 16 % intermolekulare Acetale. Carboset XL 27 ist ein Acrylharz mit der Säurezahl 80 und dem Molgewicht 50.000 (Hersteller B.F. Goodrich). Die Pigmente werden jeweils als Dispersion in einer Lösung des Polyvinylacetals in Butyrolacton und Propylenglykolmonomethylether zugegeben. Auf die lichtempfindlichen Schichten wird die in Beispiel 1 beschriebene Mowilith 30-Kleberlösung aufgebracht.

Das gelbe lichtempfindliche Material wird mit seiner Haftschicht auf das in Beispiel 2 beschriebene Bildempfangsmaterial laminiert. Die lichtempfindliche Schicht wird durch den Negativ-Gelbauszug und durch den Träger des gelben Materials mit aktinischem Licht bildmäßig belichtet. Die Belichtung durch den Träger bewirkt eine zusätzliche Lichtstreuung und führt dadurch zu einer Rasterpunktvergrößerung. Nach dem Belichten wird die Trägerfolie des gelben Materials abgezogen. Die belichtete gelbe Schicht wird dann wie oben beschrieben weiterverarbeitet.

Als nächstes wird das purpurfarbene Material auf die gelbe Bildseite laminiert, danach belichtet und dann sein Träger abgezogen. Die belichtete purpurfarbene Schicht wird anschließend weiterverarbeitet.

Auf Purpur folgt in gleicher Weise Blaugrün und dann Schwarz, so daß man auf dem Bildempfangsmaterial ein Vierfarbenbild erhält.

Die Schutzfolie besteht aus einer Antiblockierschicht in direktem Kontakt mit einer Basisfolie, und auf der Antiblockierschicht befindet sich noch eine Haftschicht. Die Antiblockierlösung hat die folgende Rezeptur:

2-Methoxy-ethanol 39 %
Butanon 39 %
Butyrolacton 10 %
Scripset 540 10 %
Carboset 5252 %

Carboset 525 ist ein Terpolymeres aus 32 % Ethylacrylat, 58 % Methylmethacrylat und 10 % Acrylsäure (MG 260.000). Die Antiblockierlösung wird zu einem Schichtgewicht von 3 g/m$^2$ auf eine 75 $\mu$m dicke, einen Füllstoff enthaltende Polyesterfolie mit matter Oberfläche (Melinex 377) aufgebracht.

Die Kleberlösung hat die folgende Rezeptur:

n-Butylacetat 50 %
UCAR VYNC 50 %

Sie wird zu einem Schichtgewicht von 8 - 10 g/m$^2$ auf die Antiblockierschicht aufgetragen.

Die Schutzfolie wird wie oben beschrieben mit ihrer Haftschicht direkt auf das Vierfarbenbild laminiert. Dann wird die Trägerfolie des Bildempfangsmaterials vorsichtig von dem Vierfarbenbild abgezogen und dieses anschließend auf Papier der Marke "Champion Kromekote 1S" laminiert. Als letzter Schritt wird die matte Basisfolie der Schutzfolie von dem Vierfarbenbild auf dem Papier abgezogen. Die Antiblockierschicht und die zugehörige Haftschicht verbleiben als Schutz auf dem Bild.

Beispiel 4

Die lichtempfindlichen Materialien werden wie in Beispiel 1 hergestellt, wobei die lichtempfindlichen Lösungen jedoch die folgenden Rezepturen haben:

| | Cyan | Gelb | Magenta | Schwarz |
|---|---|---|---|---|
| Butanon | 35,52 | 34,45 | 24,23 | 38,62 |
| Butyrolacton | 22,60 | 11,15 | 24,04 | 5,74 |
| Propylenglykolmonomethylether | 34,76 | 35,21 | 44,94 | 48,34 |
| Diacetonalkohol | | 11,74 | | |
| Scripset 540 | 1,60 | 2,01 | 2,15 | 2,39 |
| SMA 2625 | 1,74 | 1,17 | | 0,60 |
| Butvar B-90 | 0,58 | 0,59 | 0,67 | 0,30 |
| Naphthochinondiazid | 2,09 | 2,58 | 2,81 | 2,72 |
| Phthalocyaninblau | 1,11 | | | |
| gelbes Pigment | | 1,08 | | |
| purpurfarbenes Pigment | | | 1,15 | |
| schwarzes Pigment | | | | 1,29 |
| optische Dichte | 1,2 | 1,0 | 1,4 | 1,6 |

SMA 2625 ist ein Copolymeres aus Styrol und Maleinsäureanhydrid der Säurezahl 220 und mit dem Molekulargewicht 1900, Butvar B-90 ein Polyvinylbutyral (Tg 65 °C) (Hersteller Monsanto). Das Naphthochinondiazid ist das Veresterungsprodukt aus Bis-(3-benzoyl-4,5,6-trihydroxyphenyl)-methan und 1,2-Naphthochinon-2-diazid-5-sulfonylchlorid gemäß US-A 4 407 426. Die Pigmente werden jeweils als Dispersion in einer Lösung von Scripset 540 in Butanon zugegeben. Auf die lichtempfindlichen Schichten wird die in Beispiel 1 beschriebene Mowilith 30-Kleberlösung aufgebracht.

Das gelbe lichtempfindliche Material wird wie beschrieben mit seiner Haftschicht auf das in Beispiel 2 angegebene Bildempfangsmaterial, bestehend aus einer Haftschicht und einer Trägerfolie, laminiert. Nach dem Laminieren bei erhöhter Temperatur wird der Träger des gelben Materials abgezogen. Die gelbe lichtempfindliche Schicht wird im Kontakt Schicht auf Schicht unter einem Positiv-Gelbauszug mit aktinischem Licht bildmäßig belichtet. Anschließend wird die belichtete lichtempfindliche Schicht durch Weglösen der belichteten Bereiche entwickelt. Zu diesem Zweck wird sie 15 Minuten in den 23 °C warmen Entwickler aus Beispiel 1 getaucht und dann 45 Minuten mit einem entwicklergetränkten Tampon leicht überrieben. Nach dem Entwickeln wird das bebilderte Material abgespült, abgequetscht und an der Luft getrocknet.

Als nächstes wird das purpurfarbene Material auf das gelbe Bild laminiert, dann der Träger dieses Materials entfernt, die purpurfarbene lichtempfindliche Schicht passergenau unter dem Positivauszug für diese Farbe belichtet und ebenso wie die gelbe lichtempfindliche Schicht weiterverarbeitet.

Auf Purpur folgen in gleicher Weise Blaugrün und dann Schwarz, so daß man auf dem Zwischenträger ein Vierfarbenbild erhält.

Die Schutzfolie ähnelt der in Beispiel 3 beschriebenen. Sie besteht aus einer Antiblockierschicht in direktem Kontakt mit einer Basisfolie und einer Haftschicht auf der Antiblockierschicht. Die Antiblockierlösung hat die folgende Zusammensetzung:

2-Methoxy-ethanol     39 %
Butanon     39 %
Butyrolacton     10 %
Scripset 540     9,9 %
Carboset 525     2 %
Formvar 12/85     0,1 %

Formvar 12/85 soll die Haftung der Antiblockierschicht zur Basisfolie der Schutzfolie erhöhen. Es handelt sich dabei um ein Polyvinylformal (Hersteller Monsanto). Die Antiblockierlösung wird zu einem Schichtgewicht von 2 g/m² auf eine 75 Üm dicke Folie (Melinex 516) aufgetragen. Die Kleberlösung hat die folgende Zusammensezung in Gewichtsteilen:

n-Butylacetat     34
2-Methoxy-ethanol     30
Mowilith 30     20
Resoflex R-296     1

Die Kleberlösung wird zu einem Schichtgewicht von 15 g/m² auf die Antiblockierschicht aufgetragen.

Die Schutzfolie wird wie beschrieben mit ihrer Haftschicht direkt auf das Vierfarbenbild auflaminiert. Die Trägerfolie des Bildempfangsmaterials wird von dem Vierfarbenbild abgezogen und dieses dann auf Papier der Marke "Champion Kromekote 1S" laminiert. Als letzter Schritt wird die matte Basisfolie der Schutzfolie von dem Vierfarbenverbund auf dem Papier abgezogen.

## Beispiel 5

Zur Herstellung eines Bildempfangsmaterials wird eine Kleberlösung auf eine Folie aufgebracht und zu einem Schichtgewicht von 6 g/m² getrocknet. Die Kleberlösung hat die folgende Zusammensetzung:

n-Butylacetat     76 %
Mowilith 251     24 %

Auf die Haftschicht wird anschließend eine Antiblockierlösung aufgetragen und zu einem Schichtgewicht von 3 g/m² getrocknet. Die Antiblockierlösung hat die folgende Zusammensetzung:

Tetrahydrofuran     45 %
Butanon     45 %
Scripset 540     6 %

Polyvinylacetal wie im Beispiel 3     4 %

Das blaugrüne lichtempfindliche Material aus Beispiel 3 wird bei 70 °C auf die Antiblockierschicht des Bildempfangsmaterials laminiert. Die Antiblockierschicht verhindert, daß die Haftschicht des blaugrünen Materials schon vor dem Laminieren bei Raumtemperatur an dem Bildempfangsmaterial klebt.

Nach dem Laminieren wird der Träger des blaugrünen Materials abgezogen, die lichtempfindliche Schicht durch ein projiziertes negatives Bild belichtet und dann wie in Beispiel 1 beschrieben weiterverarbeitet.

Andere farbige Materialien können in gleicher Weise folgen.

Die Schutzfolie aus Beispiel 3 wird dann wie oben beschrieben mit ihrer Haftschicht auf das bebilderte Material laminiert und dann die Trägerfolie des Bildempfangsmaterials abgezogen. Die Haftschicht und die Antiblockierschicht des Bildempfangsmaterials verbleiben auf dem bebilderten Material, das anschließend auf Papier der Marke "Champion Kromekote 1S" laminiert wird. Als letzter Schritt wird die matte Basisfolie der Schutzfolie von dem blaugrünen Bild abgezogen, wobei die Antiblockierschicht und die Haftschicht der Schutzfolie auf dem bebilderten Material zurückbleiben.

<u>Beispiel 6</u>

Es werden lichtempfindliche Materialien gemäß Beispiel 3 hergestellt. Das gelbe lichtempfindliche Material wird mit seiner Haftschicht auf das Bildempfangsmaterial aus einer 178 µm dicken blau eingefärbten transparenten Polyesterfolie (Melinex XRB) laminiert. Diese Folie hat eine äußerst geringe Lichtabsorption im aktinischen Bereich (optische Dichte 0,3). Sie läßt sich visuell vom Träger der farbigen Materialien unter scheiden. Der Träger des gelben Materials wird einfach von Hand abgezogen, wobei die Haftung der Haftschicht des lichtempfindlichen Materials zum Bildempfangsmaterial größer ist als die Haftung der lichtempfindlichen Schicht zu ihrem Träger.

Die gelbe lichtempfindliche Schicht wird mit einer Quecksilber-Mitteldrucklampe belichtet. Filter, z. B. ein Kokomo-Filter, werden dabei nicht verwendet. Die Rasterpunktzunahme (dot-gain) kann durch richtige Wahl der vom Hintergrund reflektierten aktinischen Lichtmenge eingestellt werden. Die kleinste Rasterpunktzunahme wird bei der geringsten Reflexion erreicht. Das belichtete gelbe Material wird 15 Sekunden in den 27 °C warmen Entwickler getaucht und dabei auf der Schichtseite leicht überrieben. Die Haftschicht und das Bildempfangsmaterial werden durch den Entwickler nicht angegriffen. Nach dem Entwickeln wird das belichtete Material abgespült und mit warmer Luft getrocknet.

Als nächstes wird das purpurfarbene Material wie beschrieben auf das gelbe Bild laminiert, die purpurfarbene lichtempfindliche Schicht anschließend belichtet, dann der Träger abgezogen und die belichtete Schicht schließlich wie oben beschrieben weiterverarbeitet.

Auf Purpur folgen in gleicher Weise Blaugrün und dann Schwarz, so daß man auf dem Bildempfangsmaterial ein Vierfarbenbild erhält.

Die Schutzfolie besteht aus einer Antiblockierschicht in direktem Kontakt mit einer Basisfolie, und auf der Antiblockierschicht befindet sich noch eine Haftschicht. Die Antiblockierlösung hat die folgende Zusammensetzung:

2-Methoxy-ethanol     35,71 %
Butanon     35,71 %
Butyrolacton     23,81 %
Scripset 540     2,38 %
Polyvinylacetal wie in Beispiel 3     2,38 %
Formvar 12/85     0,01 %

Die Antiblockierlösung wird zu einem Schichtgewicht von 3 g/m² auf eine 75 µm dicke, pigmentierte Polyesterfolie (Melinex 377) aufgebracht.

Die Kleberlösung hat die folgende Zusammensetzung:

n-Butylacetat     68 %
Amylacetat     10 %
Mowilith 30     21 %
Resoflex R-296     1 %

Sie wird zu einem Schichtgewicht von 29 g/m² auf die Antiblockierschicht aufgetragen.

Die Schutzfolie wird wie beschrieben mit ihrer Haftschicht direkt auf das Vierfarbenbild auflaminiert. Das blaue Bildempfangsmaterial wird dann von dem Vier farbenbild abgezogen. Anschließend wird das Vierfarbenbild auf Papier der Marke "Champion Kromekote 1S" laminiert. Als letzter Schritt wird die matte Basisfolie der Schutzfolie von Hand von dem Vierfarbenbild auf dem Papier abgezogen, wobei die Antiblockierschicht und ihre Haftschicht als Schutz auf dem Vierfarbenbild zurückbleiben.


### Ansprüche

1. Verfahren zur Herstellung eines Mehrfarbenbilds, bei dem man ein lichtempfindliches Material aus einem temporären Schichtträger, einer lichtempfindlichen Schicht, die einen Farbstoff oder ein Pigment einer bestimmten Grundfarbe enthält, ggf. einer ersten wärmeaktivierbaren Haftschicht auf der lichtempfindlichen Schicht und ggf. einer ungefärbten, lichtempfindlichen oder nicht lichtempfindlichen Sperrschicht zwischen der farbigen lichtempfindlichen Schicht und der ersten Haftschicht unter Anwendung von Wärme und Druck auf ein temporäres Bildempfangsmaterial laminiert, die lichtempfindliche Schicht vor oder nach dem Laminieren unter dem zugehörigen Farbauszugsbild belichtet, den temporären Schichtträger vor oder nach dem Belichten abzieht und die Schicht durch Auswaschen der Nichtbildstellen zu einem ersten Teilfarbenbild entwickelt und bei dem man in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt, dadurch gekennzeichnet, daß man auf das erhaltene Mehrfarbenbild eine Schutzfolie, die eine Basisfolie, eine zweite Haftschicht und ggf. eine Antiblockierschicht zwischen der Basisfolie und der zweiten Haftschicht aufweist, laminiert, das Bild empfangsmaterial abzieht und das Mehrfarbenbild auf einen permanenten Bildträger laminiert, der in Struktur und Aussehen dem Bedruckstoff entspricht, auf den das entsprechende Mehrfarben-Druckbild gedruckt werden soll.

2. Verfahren nach Anspruch 1, dadurch gekennzeichnet, daß das temporäre Bildempfangsmaterial aus einer dimensionsbeständigen Trägerfolie besteht, die auf einer Oberfläche eine farblose wärmeaktivierbare dritte Haftschicht trägt.

3. Verfahren nach Anspruch 1, dadurch gekennzeichnet, daß die erste wärmeaktivierbare Haftschicht und die dritte wärmeaktivierbare Haftschicht einen Erweichungsbereich zwischen 60 und 180 °C haben.

4. Verfahren nach Anspruch 2, dadurch gekennzeichnet, daß das temporäre Bildempfangsmaterial auf der dritten wärmeaktivierbaren Haftschicht eine Antiblockierschicht aufweist, die bei Temperaturen von 50 °C oder darunter nicht blockt.

5. Verfahren nach Anspruch 1, dadurch gekennzeichnet, daß man nach dem Laminieren auf den permanenten Bildträger die Basisfolie der Schutzfolie von der Antiblockierschicht abzieht.

6. Verfahren nach einem der Ansprüche 1 bis 5, dadurch gekennzeichnet, daß die wärmeaktivierbaren Haftschichten als Hauptbestandteil Vinylacetat-oder Alkylacrylat-Polymere oder Styrol/Butadien-Copolymere enthalten.

7. Verfahren nach einem der Ansprüche 1 bis 6, dadurch gekennzeichnet, daß die Haftschichten 0,5 bis 30 μm dick sind.

8. Verfahren nach Anspruch 1, dadurch gekennzeichnet, daß die lichtempfindlichen Schichten 0,5 bis 5 μm dick sind.